Europäisches Patentamt

European Patent Office

Office européen des brevets

(19)

(11) Veröffentlichungsnummer: **0 042 524**

**A2**

(12) ## EUROPÄISCHE PATENTANMELDUNG

(21) Anmeldenummer: 81104362.9

(22) Anmeldetag: 05.06.81

(51) Int. Cl.³: **H 03 K 17/08**
**H 03 K 17/64, H 01 F 7/18**

(30) Priorität: 20.06.80 DE 3023106

(43) Veröffentlichungstag der Anmeldung:
30.12.81 Patentblatt 81/52

(84) Benannte Vertragsstaaten:
AT CH DE FR GB LI NL

(71) Anmelder: Holec GmbH
Max-Planck-Strasse 5
D-4750 Unna(DE)

(72) Erfinder: Fröhlich, Günter, Ing.
Buchenstrasse 30
D-5828 Ennepetal(DE)

(74) Vertreter: Nöth, Heinz et al,
Steinsdorfstrasse 21 - 22
D-8000 München 22(DE)

(54) **Verfahren und Schaltungsanordnung zur Unterbrechung eines Gleichstroms, der zum Speisen einer Magnetspule dient.**

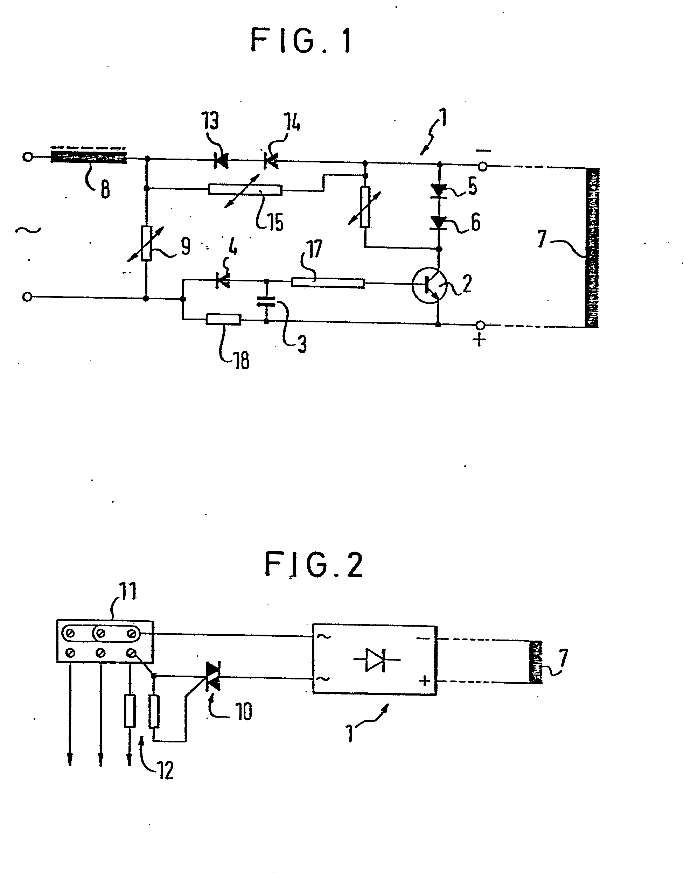

(57) Ein Verfahren und eine Schaltungsanordnung zur Unterbrechung eines Gleichstroms, der zum Speisen einer Magnetspule (7), insbesondere einer Bremslüftspule einer elektromagnetisch lüftbaren Innenbackentrommelbremse aus einer Wechselspannungsquelle mit anschließender Gleichrichtung dient, bei denen nach der Abschaltung des dem Gleichrichter (1) zugeführten Wechselstroms gleichzeitig der Gleichstromkreis unterbrochen wird und durch das Abschalten des Wechselstroms im Gleichstromkreis ein von Null bis annähernd Unendlich in einer etwa der Trennung mit Kontakten entsprechenden Zeit ansteigender Widerstand, welcher als in den Gleichstromkreis geschaltete Kollektor-Emitterstrecke eines Transistors (2) ausgebildet sein kann und in welchem die in der Magnetspule (7) gespeicherte Energie beim Abschalten des Wechselstroms in Wärme umgewandelt wird, zur Wirkung gebracht wird (Fig. 1).

FIG. 1

Verfahren und Schaltungsanordnung zur Unterbrechung eines Gleichstroms, der zum Speisen einer Magnetspule dient

Die Erfindung betrifft ein Verfahren und eine Schaltungsanordnung zur Unterbrechung eines Gleichstroms, der zum Speisen von Magnetspulen, insbesondere Bremslüftspulen elektromagnetisch lüftbarer Innenbackentrommelbremsen dient, bei dem bzw. der zwischen eine Gleichspannungsquelle
und die Magnetspule eine Gleichrichterschaltung und parallel zur Magnetspule Einrichtungen zum Ableiten der in der Magnetspule gespeicherten Energie beim Abschalten des Wechselstroms und zur gleichzeitigen Unterbrechung
des Gleichstromkreises geschaltet sind.

Zum Speisen von Magnetspulen, insbesondere von Bremslüftspulen elektromagnetisch lüftbarer Innenbackentrommelbremsen, wird eine Netzgleichrichtung vorgesehen, die aus Halbleiterventilen, z. B. Siliziumdioden, besteht. Bei Bremslüftspulen ist es notwendig, daß nach dem Abschalten des
dem Gleichrichter zugeführten Wechselstromes zusätzlich und gleichzeitig
der Gleichstromkreis, in welchem die Bremslüftspule sich befindet, unterbrochen wird, damit die Bremslüftspulenwicklung möglichst rasch stromlos
wird und damit der gewünschte Bremsvorgang durch dann wirksam werdende mechanische Druckfedern auf den angezogenen Magnetanker unverzüglich
eingeleitet wird. Nur dann ist z. B. beim Einsatz der Bremse bei einem
Hubwerk eine sichere Bremsung in definierter Hubhöhe möglich. Insbesondere bei kleineren bis mittleren Asynchronmotoren mit einer Leistung von
0, 1 - 20 kW, die eine angebaute gleichstromgespeiste Bremslüftspule aufweisen, treten sehr hohe Schaltzahlen auf, die unter Umständen einen Wert
von 5000 Schaltungen/h erreichen können. Hierbei treten neben aus dem
Wechselstromnetz kommenden Spitzenspannungen großer Höhe und extrem
kurzer Dauer, die auf die Halbleiterventile des Gleichrichters treffen können,
noch enorme Belastungen des Gleichstromschaltkontaktes auf. Bei dem

-2-

spontanen Kontaktwiderstands-Übergang von Null Ohm auf annähernd Unendlich Ohm wird die in der Bremslüftspule magnetisch gespeicherte Energie überwiegend als Lichtbogen in der Kontaktstrecke frei. Ein schneller Verschleiß des Kontaktes ist daher die Folge, und wegen der unterschiedlichen Brennzeit des Lichtbogens wird auch die Positioniergenauigkeit beim Bremsverlauf beeinträchtigt. Zudem treten Funkstörungen nach Abriß des Lichtbogens auf, die mit einem zusätzlichen Aufwand beseitigt werden müssen, der seinerseits wieder störanfällig sein kann.

Ein gewisser Schutz für den Gleichstromschaltkontakt läßt sich durch zur Bremslüftspule parallel geschaltete Widerstands-Diodenstrecken, Glimmlampenstrecken, Varistoren und Selenschutzdioden erzielen. Hierdurch nimmt man jedoch in Kauf, daß die in der Bremslüftspule gespeicherte Energie langsamer abgebaut wird und die Bremse und dgl. wieder einfallverzögert arbeitet.

Es wurde auch versucht, die Direktspeisung aus dem Niederspannungslichtnetz (220 - 550 V) durch eine aufwendige Verwendung eines Transformators, der auf 24 V herabsetzt, zu ersetzen, jedoch benötigt man auch hier wiederum Widerstands-Diodenstrecken, wobei sich zwar ein gewisser Schutz gegen Isolationsdurchschläge wegen der niedrigeren Spannungsspitzen erzielen läßt, aber es verbleibt die in der Bremslüftspule magnetisch gespeicherte und abzubauende Energie.

Aufgabe der Erfindung ist es daher, ein Verfahren und eine Schaltungsanordnung der eingangs genannten Art zu schaffen, bei der zur Abschaltung des Gleichstromkreises, in welchem die Magnetspule, insbesondere Bremslüftspule, liegt, Gleichstromkontakte, die der Gefahr des Abbrandes bei den häufigen Schaltvorgängen ausgesetzt sind, entfallen können.

Diese Aufgabe wird verfahrensmäßig dadurch gelöst, daß durch das Abschalten des Wechselstroms im Gleichstromkreis ein von Null bis annähernd Unendlich in einer etwa der Trennung mit Kontakten entsprechenden Zeit

ansteigender Widerstand, in welchem die in der Magnetspule gespeicherte Energie beim Abschalten des Wechselstroms in Wärme umgewandelt wird, zur Wirkung gebracht wird und vorrichtungsgemäß dadurch gelöst, daß der Widerstand, in welchem die in der Magnetspule gespeicherte Energie beim Abschalten des Wechselstroms in Wärme umgewandelt wird, als Innenwiderstand eines Halbleiterbauelementes ausgebildet ist.

Hierdurch läßt sich ein rascher Abbau der in der Magnetspule, insbesondere der Bremslüftspule, magnetisch gespeicherten Energie erzielen, wobei Gleichstromkontakte und die dabei durch Entstehen des Lichtbogens bedingten Schwierigkeiten in Fortfall kommen. Die gespeicherte magnetische Energie wird "funkenlos" in Wärme umgesetzt. Z.B. bei einer 100-W-Spule mit 500 Schaltungen/h entsteht im Mittel eine Dauerverlustleistung von etwa 2 W, die sich ohne weiteres auch ohne zusätzliche Kühlflächenkörper abführen lassen. Es eignet sich hierzu z.B. ein handelsüblicher Silizium-NF-Leistungstransistor, dessen Gehäuse etwa eine Gesamtfläche von 20 cm$^2$ mit einer Wärmeableitzahl von ca. 18W/m$^2$ $^o$C aufweist, so daß ohne zusätzliche Kühlflächen bei 55$^o$C Übertemperatur etwa 2 W an ruhende Luft abgegeben werden. Natürlich eignen sich auch solche Transistoren, bei denen die Gehäuseoberfläche auf etwa 20 cm$^2$ durch zusätzliche Bleche vergrößert ist.

Als zur Ableitung der in der Magnetspule, insbesondere der Bremslüftspule, gespeicherten magnetischen Energie dienender Widerstand eignet sich eine in den Gleichstromkreis geschaltete Kollektor-Emitterstrecke eines Transistors, die in Abhängigkeit vom ein- oder ausgeschalteten Wechselstrom ein- oder ausgeschaltet ist. Hierzu kann als Basisstrom des Transistors der Entladestrom eines Kondensators verwendet werden, der über einen Gleichrichter durch den Wechselstrom aufgeladen wird.

Als Gleichrichter eignet sich ein Halbleiterventil, insbesondere Doppeldioden aufweisendes Einwegsystem, das eingangsseitig mit einer Spannungsspitzenabwehrschaltung versehen ist. Diese kann bestehen aus in wenigstens einer der Wechselspannung führenden Anschlußleitungen des Gleichrichters vorgesehenen Drosselspule mit abschließendem spannungsabhängigem Widerstand, der als Varistor, insbesondere Zinkoxidwiderstand, ausgebildet sein kann. Auf diese Weise läßt sich ein sicherer Spitzenspannungsschutz erzielen, der für die Lebensdauer der Halbleiterventile des Gleichrichters wichtig ist.

Weitere Vorteile bestehen darin, daß ein kontaktloses Gleichstromschalten, insbesondere Abschalten, einer Magnetspule erzielt wird, wobei aufgrund der fehlenden Gleichstromkontakte kein Lichtbogen und damit Kontaktabbrand auftritt, und die Genauigkeit der Bremswirkung dadurch erhöht wird. Ferner entfällt die für die Gleichstromtrennung sonst übliche Installation, wodurch der Gesamtaufwand sich verringert. Darüber hinaus läßt sich eine Bremsensteuerung noch dahingehend erzielen, daß die Wechselstromzuführung zum Gleichrichter mit Hilfe eines Triacs erfolgt, der vom Strom eines an die Wechselspannungsquelle angeschlossenen Verbrauchers, insbesondere als Sättigungswandler wirkenden Stromwandlers kontaktlos erfolgt. Bei einem Drehstrommotor sind hierzu lediglich die drei Motorzuleitungen erforderlich, und es läßt sich eine Bremsensteuerung maximaler Geschwindigkeit erzielen. Eine Generatorspeisung vom Motor in die Bremse unterbleibt, die die selbsttätige Gleichstromtrennung während dieses Vorganges unterbinden könnte.

In den beiliegenden Figuren sind Ausführungsbeispiele der Erfindung dargestellt. Anhand dieser Figuren wird die Erfindung noch näher erläutert werden. Es zeigen:

Fig. 1          ein erstes Ausführungsbeispiel und

Fig. 2          ein zweites Ausführungsbeispiel.

Bei dem in der Figur 1 dargestellten Ausführungsbeispiel handelt es sich um einen Gleichrichter 1 mit einem Einwegsystem, der als Halbleiterventile Dioden 13 und 14, denen ein Varistor 15 parallel geschaltet ist, sowie Freilaufdioden 5 und 6, denen ein weiterer Varistor 16 parallel geschaltet ist, besitzt. Dieser Gleichrichter ist für den direkten Netzbetrieb in einem Bereich von 220 - 550 V und ca. maximal 500 - 1000 W Leistung
verwendbar. Dem Gleichrichter 1 ist eine Eingangsdrossel 8, insbesondere in Form einer Luftdrossel, in der einen Wechselstrom führenden Leitung und ein abschließender spannungsabhängiger Widerstand 9, der als
Varistor und insbesondere als Zinkoxidwiderstand ausgebildet sein kann,
vorgeschaltet. Bei einem ungeerdeten Einspeisungsnetz befinden sich in
beiden Wechselstrom führenden Leitungen Drosselspulen. Beim dargestellten Ausführungsbeispiel handelt es sich um einen Einweggleichrichter, bei
dem einer der beiden Netzanschlüsse auf Nullpotential liegen kann und die
Eingangsdrossel in dem Zweig liegt, der gegenüber dem Nullpotential bzw.
der Erdung die Betriebsspannung führt. Wegen der energiereichen Spannungsspitzen, die zum Teil hohe Stromstärken aufweisen, eignet sich für die Eingangsdrossel 8 bzw. Eingangsdrosseln Luftdrosseln. Durch die vorgeschaltete Kombination aus Eingangsdrossel 8 und spannungsabhängigem Widerstand 9 läßt sich bei vertretbarem Aufwand eine ausreichende Sicherheit
gegen Spannungsspitzendurchschlag des abgeschalteten Gleichrichters gewährleisten. Die ankommenden Spannungsspitzen werden durch den hohen induktiven Widerstand der insbesondere als Luftdrossel ausgebildeten Eingangsdrossel 8 wegen ihrer meist hohen Frequenz weitgehend abgeschwächt und
ihre Anstiegsflanken abgeflacht. Dadurch kann der abschließende spannungsabhängige Widerstand 9 voll zur Wirkung kommen und den Restbetrag des
Spannungsspitzenimpulses übernehmen. Eine geeignete Dimensionierung
der Eingangsdrossel 8 beträgt 0, 1 - 1 mHy. Wegen des Fehlens von Kondensatoren können spannungserhöhende Resonanzen nicht auftreten, die die
Sicherheit des Spannungsspitzenschutzes sonst beeinträchtigen würden. Für
die anliegende Nennspannung und Nennfrequenz sowie für die vorgesehenen
Ströme von einigen Ampere stellt die Eingangsdrossel 8 bei richtiger Auslegung keine Beeinträchtigung dar. Es ist lediglich mit nur 0, 5 V zusätzlichem Abfall zu rechnen. Auch wirkt sich die Eigenkapazität der Eingangsdrossel von etwa 10 pF nicht dahingehend aus, daß parallel zur Eingangsdrossel 8 der abzuwehrende Spannungsspitzenimpuls noch eindringt, da
energiereiche Spannungsspitzen über 5 MHz nicht zu erwarten sind.

In Reihe geschaltet zu den Freilaufdioden 5 und 6 ist die Kollektor-Emitterstrecke eines Transistors 2, dessen Basis vom Entladestrom eines Kondensators 3 über einen Widerstand 17 angesteuert wird. Die Aufladung des
Kondensators 3 erfolgt durch den Wechselstrom über einen als Diode 4 ausgebildeten Gleichrichter. Dieser führt den bei der ersten einlaufenden Halbwelle an einem Widerstand 18 erzeugten Spannungsabfall auf den Kondensator 3.

Das dargestellte Ausführungsbeispiel hat folgende Funktion:

Beim Einschalten des Wechselstroms an den Wechselstromklemmen erzeugt
die erste einlaufende Halbwelle am Widerstand 18 einen Spannungsabfall von
beispielsweise ca. 3 - 4 V, der von der Diode 4 auf den Kondensator 3 geführt
wird. Der Entladestrom des Kondensators 3 wird über den Widerstand 17 an
die Basis des Transistors 2 geführt, wodurch dieser durchgeschaltet wird
und die Freilaufdioden 5 und 6 wirksam werden. Es erfolgt auf diese Weise
die Versorgung einer an die Gleichstromklemmen angeschlossenen Magnetspule 7 mit Gleichstrom. Falls die Magnetspule 7 als Bremslüftspule ausgebildet ist, erfolgt die Lüftung derselben über die Dioden 13 und 14 und die
mitwirkenden Freilaufdioden 5 und 6. Nach erfolgter Lüftung der Bremslüftspule übernehmen die Widerstände 18 und 17 die Führung des Stromes, wobei bei gleicher Aufteilung deren Verluste unbedeutend und leicht beherrbar sind. Die Verluste im Transistor 2 sind nahezu Null, weshalb ein Kühlkörper nicht erforderlich ist.

Beim Abschalten des Wechselstroms wird der Kondensator 3 nicht mehr aufgeladen, weshalb der über den Widerstand 17 und die Basis-Emitterstrecke
des Transistors 2 geführte Entladestrom ständig abnimmt. Dadurch erhöht
sich der dynamische Innenwiderstand des Transistors 2 von zunächst Null
bis annähernd Unendlich. Der dynamische Innenwiderstand des Transistors
2 wirkt insofern wie ein Potentiometer, das in angemessen kurzer Zeit
den Übergang von einem Widerstandswert Null bis auf annähernd Unendlich

- ⅄ -

bewirkt und hierbei in einem optimalen Verhältnis zum Spulenwiderstand verläuft. Man erhält dadurch einen schnellstmöglichen Energieabbau bei einem auf unschädlicher Höhe gehaltenen Spannungswert der Induktionsspannung. Durch die Erhöhung des dynamischen Widerstandes wird die in der Spule 17 gespeicherte magnetische Energie im Transistor 2 in Wärme umgesetzt, die ohne weiteres abgeführt werden kann. Die Abklingzeit des Gleichstromes bei dieser selbsttätig wirkenden Gleichstromtrennung läßt sich durch entsprechende Dimensionierung des Kondensators 3 und des Widerstandes 17 in mindestens der gleichen Größenordnung wie bei der kontaktbehafteten Gleichstromtrennung erzielen. Geeignete Widerstandswerte für die Widerstände 17 und 18 sind z. B. 22 $\Omega$ und für den Kondensator 3 100 $\mu$ F/10 V. Bei einem eventuellen Transistordurchschlag wirkt der Gleichrichter weiter, d. h. es handelt sich um eine selbstsichere Elektronik, die bei Ausfall die Gleichrichterfunktion nicht beeinträchtigt. Es kann dann ohne die selbsttätig wirkende Gleichstromtrennung zumindest ein Notbetrieb aufrechterhalten werden.

Bei einer 100 W-Magnetwicklung für die Bremslüftspule 7 und bei 500 Schaltungen/h ergibt sich im Mittel eine Dauerverlustleistung von etwa 2 W, so daß für den Transistor 2 keine zusätzlichen Kühlflächenkörper notwendig sind. Die dieser Dauerverlustleistung entsprechende Wärme läßt sich nämlich ohne weiteres abführen.

Das Ausführungsbeispiel der Fig. 2 zeigt eine Anordnung, bei der mittels eines Triacs 10 und eines Stromwandlers 12 die Wechselstromzuführung zum Gleichrichter 1 kontaktlos erfolgt. Der Motorstrom übernimmt dabei die Betätigung des Triacs 12. Für den als Drehstrommotor ausgebildeten Verbraucher 11 sind lediglich drei Motorzuleitungen erforderlich. Die Betätigung der Magnetspule, insbesondere Bremslüftspule 7, erfolgt mit maximaler Geschwindigkeit. Eine Generatorspeisung vom Motor 11 in die Spule 7 unterbleibt bei dieser Anordnung. Es ergibt sich somit bei der in der Fig. 2 dargestellten Anordnung eine vorteilhafte Anwendungsmöglichkeit des in der Fig. 1 dargestellten Ausführungsbeispiels.

*LIEDL, NÖTH, ZEITLER*  **0042524**

*Patentanwälte*

Steinsdorfstr. 21-22 · D-8000 München 22 · Tel. 089/229441 · Telex: 05/22208

### HOLEC GMBH
### Max-Planck-Str. 5, 4750 Unna

Verfahren und Schaltungsanordnung zur Unterbrechung eines Gleichstroms, der zum Speisen einer Magnetspule dient

Patentansprüche:

1. Verfahren zur Unterbrechung eines Gleichstroms, der zum Speisen einer Magnetspule, insbesondere einer Bremslüftspule einer elektromagnetisch lüftbaren Innenbackentrommelbremse aus einer Wechselspannungsquelle mit anschließender Gleichrichtung dient, bei dem nach der Abschaltung des dem Gleichrichter zugeführten Wechselstroms gleichzeitig der Gleichstromkreis unterbrochen wird und dabei ein Abbau der in der Magnetspule gespeicherten Energie erfolgt, dadurch gekennzeichnet, daß durch das Abschalten des Wechselstroms im Gleichstromkreis ein von Null bis annähernd Unendlich in einer etwa der Trennung mit Kontakten entsprechenden Zeit ansteigender Widerstand, in welchem die in der Magnetspule gespeicherte Energie beim Abschalten des Wechselstroms in Wärme umgewandelt wird, zur Wirkung gebracht wird.

E 117 - N/Li

- 2 -

0042524

2. Schaltungsanordnung zur Unterbrechung eines Gleichstroms, der zum Speisen von Magnetspulen, insbesondere Bremslüftspulen elektromagnetisch lüftbarer Innenbackentrommelbremsen dient, bei der zwischen eine Gleichspannungsquelle und die Magnetspule eine Gleichrichterschaltung und parallel zur Magnetspule Einrichtungen zum Ableiten der in der Spule gespeicherten Energie beim Abschalten des Wechselstroms und gleichzeitigen Unterbrechung des Gleichstromkreises geschaltet sind, zur Durchführung des Verfahrens nach Anspruch 1, dadurch gekennzeichnet, daß der Widerstand, in welchem die in der Magnetspule gespeicherte Energie beim Abschalten des Wechselstroms in Wärme umgewandelt wird, als Innenwiderstand eines Halbleiterbauelementes ausgebildet ist.

3. Schaltungsanordnung nach Anspruch 2, dadurch gekennzeichnet, daß der Innenwiderstand als in den Gleichstromkreis geschaltete Kollektor-Emitterstrecke eines Transistors (2) ausgebildet ist, dessen Basis durch den gleichgerichteten Wechselstrom angesteuert wird.

4. Schaltungsanordnung nach Anspruch 3, dadurch gekennzeichnet, daß der Basisstrom des Transistors (2) der Entladestrom eines Kondensators (3) ist, der über einen Gleichrichter (4) durch den Wechselstrom aufgeladen wird.

5. Schaltungsanordnung nach Anspruch 3 oder 4, dadurch gekennzeichnet, daß die Kollektor-Emitterstrecke des Transistors (2) in Reihe geschaltet ist mit einem Gleichrichter (5, 6) und diese Reihenschaltung parallel zur Magnetspule (7) in den Gleichstromkreis geschaltet ist.

6. Schaltungsanordnung nach einem der Ansprüche 3 bis 5, dadurch gekennzeichnet, daß dem aus Halbleiterventilen (5, 6) bestehenden Gleichrichter in wenigstens einer den Wechselstrom führenden Anschlußleitung eine Drosselspule (8) und ein dem Gleichrichter (5, 6) parallel geschalteter spannungsabhängiger Widerstand (9) vorgeschaltet sind.

7.   Schaltungsanordnung nach einem der Ansprüche 2 bis 5, d a d u r c h
g e k e n n z e i c h n e t ,   daß die Wechselstromzuführung mit Hilfe eines
Triacs (10),der vom Strom eines an die Wechselspannungsquelle angeschlossenen Verbrauchers (11) betätigt wird,und eines Stromwandlers (12) kontaktlos erfolgt.

# FIG. 1

# FIG. 2